(19) Europäisches Patentamt / European Patent Office / Office européen des brevets

(11) **EP 2 722 985 B1**

(12) **EUROPEAN PATENT SPECIFICATION**

(45) Date of publication and mention
of the grant of the patent:
**10.02.2016 Bulletin 2016/06**

(51) Int Cl.:
***H03K 17/00*** *(2006.01)*     ***H03K 17/96*** *(2006.01)*

(21) Application number: **12461553.5**

(22) Date of filing: **16.10.2012**

(54) **Method of differential measurement of voltage levels of capacitive change.**

Verfahren zur Differentialmessung der Spannungspegeln einer kapazitiven Veränderung.

Procédé de mesure différentielle des niveaux de voltage de change de capacité.

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**23.04.2014 Bulletin 2014/17**

(73) Proprietor: **Diehl AKO Stiftung & Co. KG
88239 Wangen (DE)**

(72) Inventor: **Koziol , Krzysztof
48-340 G ucho azy (PL)**

(74) Representative: **Seidel, Michael
Diehl Stiftung & Co. KG
Zentrale Patentabteilung
Stephanstraße 49
D-90478 Nürnberg (DE)**

(56) References cited:
**US-A1- 2008 246 723    US-A1- 2008 277 171
US-A1- 2009 224 776    US-A1- 2009 243 632
US-A1- 2010 102 832    US-A1- 2011 074 609**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

The present invention relates to a method of differential measurements of the voltage for capacitive touch sensors technology using a constant current charge/discharge technique. The measurement result is a difference of voltage levels measured after charging and discharging the capacity. This method is going to be used for a capacitive touch sensors or keyboards or sliders or screens or proximity sensors. It helps to reduce the external high frequency noise impact and improve the EMC immunity.

Capacitive sensors such as touch buttons are nowadays widely known and used in various electronic devices, control panels, mobile phones, tablets, calculators, etc and they are still growing popular. In particular, capacitive sensors are employed in touch screens which provide user interface for controlling many devices in various fields of art. They have successfully replaced former push-buttons or mechanical switches well known from the prior art. In contrast to the latter, capacitive touch sensors do not need to be manually switched by applying a force (e.g., biased, pressed etc.), but they use a detection of capacitance change that occurs when, for example, an user put his finger in close proximity to the capacitive touch sensor. The capacitive touch sensors have many advantages over mechanical buttons, due to their versatility, reliability, robustness and lower costs.

The principle of operation of the capacitive sensors is based on the effect of electric charge change at the electrode (being a sensing area) dependent on a presence of, e.g. a human finger or other object close to the electrode. A most common solution employs en electronic driver, e.g. microcontroller that continually charges the electrode by applying a fixed amount of current for a predetermined time period. After the predetermined time period a difference between the high and low voltages at the electrode is measured. If other conducting object comes into proximity of the electrode, e.g. a human finger, the measured voltage difference changes because of the capacitance change.

Up to now, there were used several solutions of capacitive touch switch.

United States Patent No. US 7,375,656 B2, Bernd Raunig, discloses a circuit configuration for a capacitive touch switch which contains at least one sensor circuit with a capacitive sensor element which changes its capacitance value when touched, and an evaluation circuit which is supplied with an output signal from the sensor circuit in order to determine whether the capacitive sensor element is actuated or not.

United States Patent Application No. US 2007/0181412 A1, Müller et al., discloses a capacitive touch switch which is used, for example, in a control device for an electronic domestic appliance, which includes a sensor area as part of a capacitance sensor element having a capacitance which changes when touched.

However, above-mentioned solutions are either no cost effective, too sensitive for high frequency noise or have low sensitivity of capacitance change detection.

US Patent Application No. US 2010/0102832 A1 discloses a microchip having a charge time measurement unit (CTMU) method, but it uses only a constant current charge in contrast to the proposed charge/discharge method.

The object of the present invention is to provide, independent of the control device (e.g. microcontroller, microprocessor, ASIC device, DSP etc.), the architecture for measuring a small capacitance change e.g. capacitive touch sensors/keyboards/sliders/screens/proximity sensors. It helps to solve the high frequency noise immunity problem in capacitance touch technology.

SUMMARY OF THE INVENTION

According to the present invention there is provided a method of differential measurements of the voltage for capacitive touch sensors in a circuit comprising a sensor line connecting a charge current source, a discharge current source, one or more capacitive touch sensors and a port of a control device, wherein the control device controls a switching of the sensor line to a low state voltage and to a high state voltage. The method comprises the following steps:

    a) the sensor line is cleared by the control device switching it to the low state voltage (GND);
    b) the charge current source is activated for a specified time *(t_charge)*;
    c) a level on the port (ADC) is read by the control device and is stored as a charge voltage level ($V_{charge}$);
    d) the sensor line is cleared by the control device switching it to the high state voltage (Vcc);
    e) the discharge current source is activated for a specified time *(t_discharge)*;
    f) the voltage level on the port (ADC) is read by the control device and is stored as a discharge voltage level *($V_{discharge}$)*;
    g) the control device calculates a value of difference between the charge voltage level ($V_{charge}$) and the discharge voltage level ($V_{discharge}$) according to the expression:

$$V_{dif\_abs} = |V_{discharge} - V_{charge}|$$

where $V_{dif\_abs}$ is an absolute value of the difference between the charge voltage level and discharge voltage level; $V_{charge}$ is the charge voltage level; and $V_{discharge}$ is a discharge voltage level.

The method can be carried out when steps d), e) and f) are performed before steps a), b) and c).

Preferably, the method is repeated on periodical basis.

Preferably, a value of difference between the charge voltage level ($V_{charge}$) and the discharge voltage level ($V_{discharge}$) is calculated according to the expression:

$$V_{dif\_signed} = V_{discharge} - V_{charge}.$$

wherein $V_{dif\_Signed}$ is a signed value of the difference between the charge voltage level and discharge voltage level.

Preferably, the current source, either charging or discharging one can be any type of current source circuitry which gives a constant or a non-constant current.

Preferably, the value of the current charging or discharging the capacitive touch sensor depends on the time in which the measurement is performed.

Preferably, the measurement is performed for multiple capacitive touch sensors, for example, in the form of a keyboard or a slider or a screen or proximity sensors connected directly to the control device.

Preferably, the measurement is performed for multiple capacitive touch sensors, for example, in the form of a keyboard or a slider or a screen or proximity sensors connected to the control device with use of an electronic circuitry which allows multiple lines to be measured.

The object of the present invention is achieved by a method of differential measurements of the voltage for capacitive touch sensors comprising the following steps: the sensor line is cleared by the control device switching it to the low-state voltage; the charge current source is activated for a specified time *(t_charge)*; a voltage level on the port (ADC) is read by the control device and is stored as a charge voltage level (*$V_{charge}$*); the sensor line is cleared by the control device switching it to the high-state voltage; the discharge current source is activated for a specified time *(t_discharge)*; the voltage level on the port (ADC) is read by the control device and is stored as a discharge voltage level (*$V_{discharge}$*); the control device calculates a value of the difference between the charge voltage level and the discharge voltage level according to the expression:

$$V_{dif\_abs} = |V_{discharge} - V_{charge}|$$

where $V_{dif\_abs}$ is an absolute value of the difference between the charge voltage level and the discharge voltage level; $V_{charge}$ is the charge voltage level; and $V_{discharge}$ is the discharge voltage level.

The object of the present invention can be also achieved by a method of differential measurements of the voltage for capacitive touch sensors comprising the following steps: the sensor line is cleared by the control device switching it to the high state voltage; the discharge current source is activated for a specified time *(t_discharge)*; a voltage level on the port (ADC) is read by the control device and is stored as a discharge voltage level (*$V_{discharge}$*); the sensor line is cleared by the control device switching it to the low state voltage; the charge current source is activated for a specified time *(t_charge)*; the voltage level on the port (ADC) is read by the control device and is stored as a charge voltage level (*$V_{charge}$*); the control device calculates a value of difference between the charge voltage level (*$V_{charge}$*) and discharge voltage level (*$V_{discharge}$*) according to the expression:

$$V_{dif\_abs} = |V_{discharge} - V_{charge}|$$

Other features of the invention will be apparent from the dependent claims, and the description which follows.

The object of the present invention is achieved by using two independent current sources and a differential method of measurement. In comparison to the solutions known from the prior art, the present invention provides control device independency, lower price of the used components, and better EMC results. The main novel feature of the present invention is a differential measurement of the capacitance change by using a charge/discharge method.

BRIEF DESCRIPTION OF THE DRAWINGS

An example of a method of differential measurements for capacitive touch sensors technology using constant current charge/discharge technique in accordance with the present invention will now be described by way of example and with reference to the accompanying drawings in which:

Fig. 1 represents a time versus voltage diagram illustrating charge/discharge period timings, wherein solid line indicates the voltage corresponding to a situation when capacitive touch sensor is not pressed, and dashed line indicates the voltage corresponding to a situation when capacitive touch sensor is pressed.

Fig. 2 represents a block diagram of circuit arrangement with a single capacitive touch sensor for performing the method according to the present invention.

Fig. 3 represents a block diagram of circuit arrangement with multiple capacitive touch sensors (keyboard/slider/screen/proximity sensors) using analog multiplexer for performing the method according to the present invention.

DETAILED DESCRIPTION OF THE INVENTION

This method according to the present invention uses differential measurement of capacitance change by using a charging/discharging technique by constant current. Two results (of charging and discharging) are the voltage levels. In the method these two values are subtracted from each other. When the capacitance has increased, the difference is greater than before. In that manner, it's possible to detect if the capacitive touch sensor was touched. By using this technique the noise impact of the measurement has been reduced.

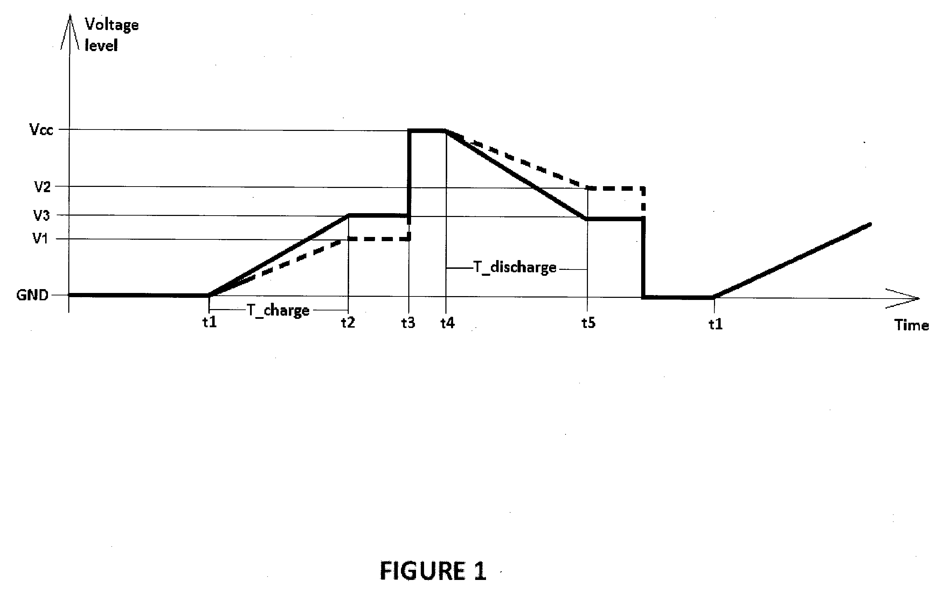

Referring to Fig. 1, when the capacitive touch sensor is "not pressed" the difference of the charge/discharge result voltage levels is small. A course for such a case is presented in the figure by solid line. In the special case the voltage difference equals 0 (the voltage level is marked as V3). When the capacitive touch sensor is "pressed" the difference increases, as indicated by a dashed line. In this case, the resulting voltage difference is defined as the difference between V2 and V1 voltage levels. In other words, when the capacitance of the capacitive touch sensor increases, the difference of the voltage levels of charge/discharge procedure increases, too. An embodiment of the method of differential measurements for capacitive touch sensors using constant current charge/discharge technique is described below in details with reference to Fig. 1. The embodiment of the method according to the invention is performed on a periodical basis, i.e. by repeating a cycle of measurements and calculations. At the beginning of each cycle, the control device switches a sensor line to the low-state voltage and the sensor line is cleared. The sensor line is the line which connects the capacitive touch sensor S1, the port ADC and current sources I1 and I2. In the present embodiment a low-state voltage is represented by the ground voltage GND but in other cases a low reference voltage can also be used. In time t1 a charge current source I1 is activated and the control device starts to countdown the specified t_charge time. During this period the sensor line is charged until time t2 in which the voltage level on the port ADC is read by control device and the result value $V_{charge}$ is stored in memory of the control device. Then, in time t3 the sensor line is cleared. It is achieved by the control device which switches the sensor line to the high state voltage, Vcc. Also other high reference voltage can be used. The discharge current source I2 is activated in time t4 and the control device starts to countdown the specified t_discharge time during which the sensor line is discharged, and in time t5 the voltage level on the port ADC is read by control device. The result value $V_{discharge}$ is stored in memory of the control device. Having two stored voltage levels, the control device, e.g. microcontroller calculates the voltage difference between the charge level and the discharge level according to the formula:

$$V_{dif\_abs} = |V_{discharge} - V_{charge}|$$

where $V_{dif\_abs}$ is an absolute value of the difference between the charge voltage level and discharge voltage level; $V_{charge}$ is a charge voltage level; and $V_{discharge}$ is a discharge voltage level. Depending on the voltage difference, the control device determines that the capacitive touch sensor is "pressed" (dashed course) or "not pressed" (solid course). This determination could be made, for example, by comparing the value of the voltage difference to a certain threshold value. If the value of the voltage difference is greater than threshold value, the control device determines that the capacitive touch sensor is "pressed". Otherwise, the control device determines that the capacitive touch sensor is "not pressed" .

Then the whole method starts from the beginning for the new capacitive touch sensor reading. In other embodiments, the voltage difference can also be a signed value calculated according to formula:

$$V_{dif\_signed} = V_{discharge} - V_{charge}$$

It should be noted that due to the periodic nature of the method, in other embodiments the method according to the invention can also start with clearing with high state voltage and discharging, followed by clearing with low state voltage and charging and calculating the voltage difference.The charge/discharge concept can increase the high frequency noise immunity, e.g. injected currents noise. When the charge and discharge time is short, the noise can be injected in the same phase to each process. Then, after subtracting, the noise is decreased when the signal is increased. The formulas below explain it.

$$V_{dif\_abs} = |(V_{discharge} + V_{noise}) - (V_{charge} + V_{noise})|$$

$$V_{dif\_abs} = |V_{discharge} - V_{charge}|$$

where $V_{dif\_abs}$ is an absolute value of the difference between the charge voltage level and discharge voltage level; $V_{charge}$ is a charge voltage level; $V_{discharge}$ is a discharge voltage level and $V_{noise}$ is a noise voltage.

Furthermore, the value of the current charging or discharging the capacitive touch sensor may depend on the time in which the measurement has to be done. To increase the noise immunity it is better to use a shorter time than a longer one, it means that in order to achieve higher accuracy the current has to have higher value.

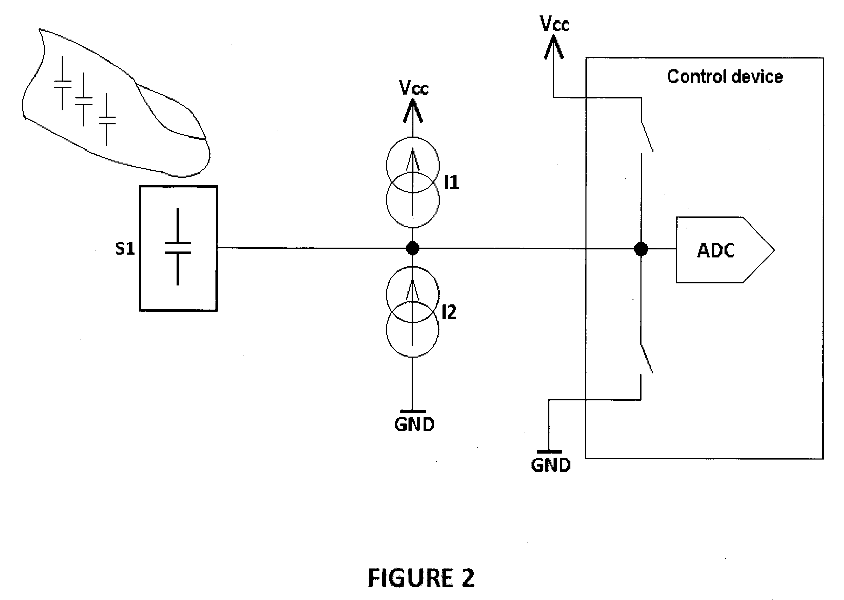

Fig. 2 represents a block diagram of a circuit arrangement with a single capacitive touch sensor for performing the method according to the present invention. Capacitive touch sensor S 1 may be a part of PCB layout or any other part which can transfer the charge from the outside into the circuit. Capacitive touch sensor S1 is connected to an electrical line which connects it to current sources I1 and I2 and to the ADC part of the control device. Current sources can deliver constant or not-constant current to the sensor line. The control device is any device suitable for controlling the charge-discharge process. ADC part is a part of the control device or external device which converts the voltage level to a value which can be processed by the control device, e.g. analog-to-digital converter but it can also be a comparator, a windowed comparator, etc.

Current source, either charge current source I1 or discharge current source I2, can be any type of electronic circuitry which gives a constant or a non-constant current. In the simplest way it can be a single resistor which limits the current taken from or supplied to the power line. The value of the charge and discharge level can be adjusted by changing the current of the current source I1 (charge) and I2 (discharge) as it can be seen in Fig. 2.

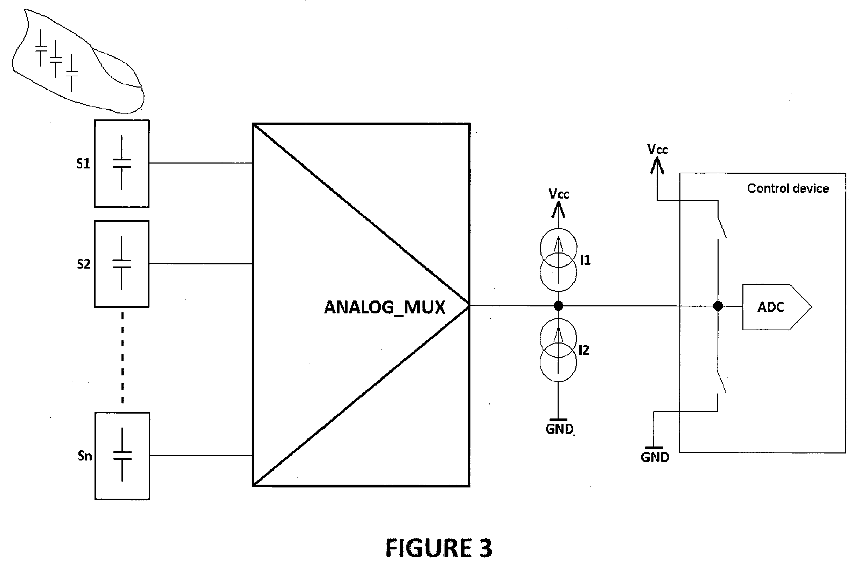

Fig. 3 represents a block diagram of a circuit arrangement with multiple capacitive touch sensors (keyboard/slider/screen/proximity sensor) using an analog multiplexer for performing the method according to the present invention. The depicted block diagram is similar to the one presented in the Fig.2 with the difference that it employs an analog multiplexer ANALOG_MUX connected to the electrical line. Such a solution enables increasing the number of capacitive touch sensors S1...Sn, without increasing the used amount of control device ports and of charge/discharge current sources, with use of an electronic circuitry which expands the lines to be measured. Such an electronic device can be e.g. an analog multiplexer ANALOG_MUX, as depicted in Fig. **3**, or a similar device, for example an expander. The method of measurement according to the invention has to be repeated for each capacitive touch sensor. The control device has to set the expander input before each capacitive touch sensor read procedure.

## Claims

1.  A method of differential measurements of the voltage for capacitive touch sensors in a circuit comprising a sensor line connecting a charge current source (I1), a discharge current source (I2), one or more capacitive touch sensors (S1...Sn) and a port (ADC) of a control device, wherein the control device controls a switching of the sensor line to a low-state voltage (GND) and to a high-state voltage (Vcc), wherein the method comprises the steps:

    a) the sensor line is cleared by the control device switching it to the low-state voltage (GND);
    b) the charge current source (I1) is activated for a specified time *(t_charge)*;
    c) a voltage level on the port (ADC) is read by the control device and is stored as a charge voltage level ($V_{charge}$);
    d) the sensor line is cleared by the control device switching it to the high-state voltage (Vcc);

e) the discharge current source (12) is activated for a specified time *(t_discharge)*;

f) the voltage level on the port (ADC) is read by the control device and is stored as a discharge voltage level (***V_discharge***);

g) the control device calculates a value of the difference between the charge voltage level (***V_charge***) and the discharge voltage level (***V_discharge***) according to the expression:

$$V_{dif\_abs} = |V_{discharge} - V_{charge}|$$

where $V_{dif\_abs}$ is an absolute value of the difference between the charge voltage level and the discharge voltage level; $V_{charge}$ is the charge voltage level; and $V_{discharge}$ is the discharge voltage level.

2. The method according to claim 1, wherein the steps d), e) and f) are performed before the steps a), b) and c).

3. The method according to claim 1 or 2, wherein the method is repeated on a periodical basis.

4. The method according to any preceding claim, wherein a value of the difference between the charge voltage level ($V_{charge}$) and the discharge voltage level ($V_{discharge}$) is calculated according to the expression:

$$V_{dif\_signed} = V_{discharge} - V_{charge}$$

wherein $V_{dif\_signed}$ is a signed value of the difference between the charge voltage level and the discharge voltage level.

5. The method according to any preceding claim, wherein the current source, either charge one (I1) or discharge one (I2) can be any type of a current source which gives a constant or a non-constant current.

6. The method according to any preceding claim, wherein the value of the current charging or discharging the capacitive touch sensor (S1) depends on the time in which the measurement is performed.

7. The method according to any preceding claim, wherein the measurement is performed for multiple capacitive touch sensors (S1...Sn) connected directly to the control device.

8. The method according to any preceding claim, wherein the measurement is performed for multiple capacitive touch sensors (S1...Sn) connected to the control device with use of an electronic circuitry which allows multiple lines to be measured.

**Patentansprüche**

1. Verfahren zur Differenzspannungsmessungen bei kapazitativen Tastsensoren in einer Anordnung, die eine die Ladestromquelle (I1), Entladestromquelle (I2), einen oder mehrere kapazitative Tastsensoren (S1...S2) und die Steuergerätschnittstelle (ADC) verbindende Sensorleitung beinhaltet, wobei das Steuergerät das Umschalten der Sensorleitung in die Niederzustandsspannung (GND) und die Hochzustandsspannung (Vcc) steuert, wobei das Verfahren folgende Schritte umfasst:

a) die Sensorleitung wird durch das Steuergerät gelöscht, das sie in die Niederzustandsspannung (GND) umschaltet;

b) Die Ladestromquelle (I1) wird über eine entsprechende Dauer *(t_charge)* aktiviert;

c) Der Spannungspegel an der Schnittstelle (ADC) wird vom Steuergerät abgelesen und als Ladespannungspegel (***V_charge***) gespeichert;

d) Die Sensorleitung wird durch das Steuergerät gelöscht, das sie in die Hochzustandsspannung (Vcc) umschaltet;

e) Die Entladestromquelle (I2) wird über eine entsprechende Dauer *(t_discharge)* aktiviert;

f) Der Spannungspegel an der Schnittstelle (ADC) wird vom Steuergerät abgelesen und als Entladespannungspegel (***V_discharge***) gespeichert;

g) Das Steuergerät berechnet den Differenzwert zwischen dem Ladespannungspegel ($V_{charge}$) und dem Entladespannungspegel ($V_{discharge}$) nach der Formel:

$$V_{dif\_abs} = |V_{discharge} - V_{charge}|$$

wobei $V_{dif\_abs}$ ein absoluter Differenzwert zwischen dem Ladespannungspegel und dem Entladespannungspegel; $V_{charge}$ der Ladespannungspegel; und $V_{discharge}$ der Entladespannungspegel ist.

2. Verfahren nach Anspruch 1, in dem die Schritte d), e) und f) vor den Schritten a), b) und c) ausgeführt werden.

3. Verfahren nach Anspruch 1 oder 2, in dem das Verfahren regelmäßig wiederholt wird.

4. Verfahren nach einem der vorigen Ansprüche, in dem der Differenzwert zwischen dem Ladespannungspegel ($V_{charge}$) und dem Entladespannungspegel ($V_{discharge}$) nach der Formel berechnet wird:

$$V_{dif\_signed} = V_{discharge} - V_{charge}$$

wobei $V_{dif\_signed}$ ein Wert mit einem Differenzzeichen zwischen dem Ladespannungspegel und dem Entladespannungspegel ist.

5. Verfahren nach einem der vorigen Ansprüche, in dem die Stromquelle, sowohl die Ladestromquelle (I1), als auch die Entladestromquelle (I2) eine beliebige Stromquellenart sein darf, die Gleichstrom oder Wechselstrom liefert.

6. Verfahren nach einem der vorigen Ansprüche, in dem der Ladestromwert oder der Entladestromwert für den kapazitiven Tastsensor (S1) von der Zeit abhängt, in der die Messung erfolgt.

7. Verfahren nach einem der vorigen Ansprüche, in dem die Messung für mehrere direkt mit dem Steuergerät verbundene kapazitative Tastsensoren (S1...Sn) durchgeführt wird.

8. Verfahren nach einem der vorigen Ansprüche, in dem die Messung für mehrere direkt mit dem Steuergerät verbundene kapazitative Tastsensoren (S1...Sn) mit Einsatz einer elektronischen Schaltung durchgeführt wird, die die Messung mehrerer Leitungen ermöglicht.

**Revendications**

1. Procédé de mesure différentielle de tension pour des capteurs tactiles capacitifs dans un circuit comprenant une ligne de senseurs reliant une source de courant de charge (I1), une source de courant de décharge (I2), un ou un plus grand nombre de capteurs tactiles capacitifs (S1...Sn) ainsi qu'un port (ADC) d'un dispositif de commande, ledit dispositif de commande contrôlant la commutation de la ligne de senseurs en tension de bas niveau (GND) et en tension de haut niveau (Vcc), et ledit procédé compred les étapes suivantes :

a) la ligne de senseurs est effacée par le dispositif de commande pour la commuter en tension de bas niveau (GND);
b) la source de courant de charge (I1) est activée pendant un temps déterminé (*t_charge*);
c) le niveau de tension sur le port (ADC) est lu par le dispositif de commande et il est conservé comme niveau de tension de charge (*V_{charge}*) ;
d) la ligne de senseurs est effacée par le dispositif de commande pour la commuter en tension de haut niveau (Vcc);
e) la source de courant de décharge (I2) est activée pendant un temps déterminé (*t_discharge*);
f) le niveau de tension sur le port (ADC) est lu par le dispositif de commande et il est conservé comme niveau de tension de décharge (*V_{discharge}*) ;

g) le dispositif de commande calcule la valeur d'une différence entre le niveau de tension de charge ($V_{charge}$) et le niveau de tension de décharge ($V_{discharge}$) conformément à la relation suivante :

$$V_{dif\_abs} \; = \; |V_{discharge} \; - \; V_{charge}|$$

où $V_{dif\_abs}$ constitue la valeur absolue de la différence entre le niveau de tension de charge et le niveau de tension de décharge; $V_{charge}$ constitue le niveau de tension de charge; et $V_{discharge}$ constitue le niveau de tension de décharge.

2.  Procédé selon la revendication 1, dans lequel les étapes d), e) et f) sont réalisées avant les étapes a), b) et c).

3.  Procédé selon la revendication 1 ou 2, dans lequel le procédé est répété périodiquement.

4.  Procédé selon l'une des revendications précédentes, dans lequel la valeur de la différence entre le niveau de tension de charge ($V_{charge}$) et le niveau de tension de décharge ($V_{discharge}$) est calculée conformément à la relation suivante :

$$V_{dif\_signed} = \; V_{discharge} \; - \; V_{charge}$$

où $V_{dif\_signed}$ constitue une valeur au signe de différence entre le niveau de tension de charge et le niveau de tension de décharge.

5.  Procédé selon l'une des revendications précédentes, dans lequel la source de courant, la source de courant de charge (I1) aussi bien que la source de courant de décharge (I2), peut être une source de courant quelconque, qui fournit un courant continu ou alternatif.

6.  Procédé selon l'une des revendications précédentes, dans lequel la valeur du courant de charge ou de celui de décharge du capteur tactile capacitif (S1) dépend du temps de réalisation de la mesure.

7.  Procédé selon l'une des revendications précédentes, dans lequel la mesure est réalisée pour plusieurs capteurs tactiles capacitifs (S1...Sn) reliés directement au dispositif de commande.

8.  Procédé selon l'une des revendications précédentes, dans lequel la mesure est réalisée pour plusieurs capteurs tactiles capacitifs (S1...Sn) reliés au dispositif de commande à l'aide d'un réseau électronique qui permet la mesure de plusieurs lignes.

FIGURE 1

FIGURE 2

FIGURE 3

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 7375656 B2, Bernd Raunig
- US 20070181412 A1, Müller
- US 20100102832 A1